Europäisches Patentamt

European Patent Office

Office européen des brevets

(19)

(11) EP 0 801 414 A2

(12) **EUROPEAN PATENT APPLICATION**

(43) Date of publication:
**15.10.1997 Bulletin 1997/42**

(51) Int Cl.$^6$: **H01J 37/32**

(21) Application number: **97850056.9**

(22) Date of filing: **14.04.1997**

(84) Designated Contracting States:
**AT BE CH DE ES FR GB IT LI LU NL PT SE**

(30) Priority: **12.04.1996 US 631535**

(71) Applicant: **Multi-Arc Inc.**
**Rockaway, New Jersey 07866 (US)**

(72) Inventors:
• **Rogozin, Alexander F.**
**Budd Lake, New Jersey 07828 (US)**

• **Fontana, Raymond P.**
**Waldwick, New Jersey 07463 (US)**

(74) Representative: **Rostovanyi, Peter et al**
**AWAPATENT AB,**
**Box 5117**
**200 71 Malmö (SE)**

(54) **Gas-controlled arc vapor deposition apparatus and process**

(57) An improved gas controlled arc vapor deposition process and apparatus are disclosed. Process gas is selectively introduced through the cathode evaporation surface of a cathode to create and maintain a process gas activation zone immediately adjacent to the cathode evaporation surface. Cathode structures having process gas passageways formed therethrough and porous cathode structures configured from gas permeable materials are disclosed. The concentrated introduced gas in the process gas activation zone significantly increases the degree of excitation, dissociation and ionization level of process gas atoms and molecules, which sharply lowers the threshold of synthesis reaction on the cathode evaporation surface and changes the nature and operation of the cathode spots. Deposition coating processes are performed at low chamber gas pressures, enabling more of the highly charged plasma particles from the process gas activation zone to reach the substrate, for providing dense, smooth, hard, macroparticle-free coatings with more efficiency and at higher deposition rates.

FIG.2

## Description

### Field of the Invention

This invention relates generally to physical vapor deposition processes for coating substrates in an evacuated atmosphere, and more particularly to an improved electric arc physical vapor deposition apparatus and process that uses process gas at low chamber pressures to produce improved substrate coatings.

### Background of the Invention

The physical vapor deposition art generally encompasses that art for applying or depositing a coating layer on a substrate surface within an evacuated vapor deposition chamber. Although a large number of variations and techniques for implementing process steps in the technology have been developed, the general process is the same for all physical vapor deposition techniques. The substrate to be coated is placed within a deposition chamber, which is typically evacuated and maintained at a negative pressure level during the deposition coating process. At least a portion of the coating material to be deposited is generally present in the deposition chamber in nongaseous form and is typically a solid sacrificial source material. The source material is acted upon by an energy stimulus that converts the source material into a vaporous plasma of coating material. The most commonly used physical vapor deposition techniques for converting the solid coating source material into a gaseous/vapor plasma are: resistance or induction heating, electron beam or ion bombardment, and electric arc. This invention relates to the electric arc physical vapor deposition process.

In the electric arc physical vapor deposition process, an electric arc is struck and maintained between the coating source material, which is typically electrically biased to serve as a cathode, and an anode, which is spaced apart from the cathode. The high current density electric arc, which typically ranges from thirty to several hundred amperes, vaporizes the source material where the arc "touches" the cathode. The vaporized source material forms a plasma in the cathode region of the arc discharge which includes neutral atoms, molecules of residual or reactive gas (if any is used), ionized atoms and molecules.

The cathode evaporation surface is that surface of the cathode or source to which the electric arc attaches, and the arc terminus or attachment spot which is visible on the cathode evaporation surface is typically referred to as a "cathode spot." One or more such cathode spots may exist on the cathode surface at a time, depending upon the level of current in the arc. Compound coatings may be deposited and/or formed on the substrate by introducing reactive gases into the chamber. Such reactive gases combine with the source material vaporized from the cathode and form a part of the coating plasma. The physical vapor deposition arc process, as it has been conventionally known, is described in U.S. Pat. No. 3,625,848 to Snaper; U.S. Pat. No. 3,793,179 to Sablev et al.; and U.S. Pat. No. 4,448,799 to Bergman et al. The reader is referred to such disclosures, which are herein incorporated by reference, to the extent that they may assist in a more detailed description of the prior art related to this technology.

Significant advantages of the physical vapor deposition arc process over other prior art physical vapor deposition techniques derive in large measure from the fundamental properties of cathodic vacuum arc discharges which generate plasma jets from the active cathode spots on the cathode evaporation surface. The primary advantages of this technology are its simplicity and cost effective use of plasma sources for producing a dense and highly ionized plasma flow. However, the cathodic vacuum arc technology is burdened by several inherent problems which also relate back to the method in which the plasma is formed at the cathode evaporation surface by the intensely energetic cathode spot(s).

The electric arc inherently generates a large number of undesirable droplets or macroparticles from the cathode evaporation surface. Such macroparticles enter the plasma stream, and when deposited on the substrate being coated, degrade the deposited film's properties, by among other things, increasing the porosity and roughness of the deposited coating surfaces. The existence of macroparticles in such deposited coatings has in large part precluded use of this technique in the more demanding areas of optics and electronics and has restricted its application primarily to tribological applications. It is desirable, therefore, to minimize or eliminate macroparticles and/or their generation in the arc deposition process, and considerable research has been directed toward the issue.

One technique that has been used for removing macroparticles from the plasma stream prior to deposition of the plasma coating on a substrate is to use a suitable shield or filter to physically catch or deflect the macroparticles from the substrate surface. Such processes are typically referred to in the art as "filtered arc processes." An example of a macroparticle filter apparatus of the prior art is illustrated in U.S. Pat. No. 4,452,686 to Axenov et al. Filtered arc processes may remove macroparticles, but are very inefficient. By physically removing macroparticles from that coating plasma which impinges on the substrate, a significant portion of the coating plasma created at the cathode surface is lost in the filtering process, thereby significantly reducing the coating efficiency of the system.

Another approach for reducing macroparticles in arc plasma coatings has been to minimize their formation at the cathode evaporation surface. This can be done to some extent by constraining or controlling the arc motion at the cathode evaporation surface using a very intense magnetic field, and has sometimes been referred to as a "steered arc" mode of operation. This technique is described in Patent No. W085/03954, 1985 to Ramalingam entitled "Controlled Vacuum Arc Material Deposition, Method and Apparatus."

Yet another technique for minimizing macroparticles in the deposited coating has been to use intense magnetic fields to both minimize their formation at the cathode evaporation surface, and to vaporize those macroparticles that are generated, as described more fully in U.S. Pat. No. 5,458,754 to Sathrum et al. This process creates a highly energized coating plasma that does not suffer from the coating inefficiencies of the filtered arc process techniques. However, specialized magnetic field generating means are required to produce the energizing fields, making this technique less attractive for universal retrofitting of conventional arc deposition systems.

It has long been known in the physical vapor deposition arc processing art, that gases such as nitrogen, oxygen, methane, and the like can be introduced into the evacuated chamber to react with the vaporized source material, to form a compound coating plasma. The use of such gases, however, has not heretofore been effectively employed in an electric arc deposition process to eliminate or minimize the formation of macroparticles in the source vaporization process. Several publications (A.F. Rogozin, L.U. Rusin, "Molecular Beam Diagnostics of a Chemical Active Vacuum Arc Plasma. The influence of Argon and Nitrogen.", Sov. Chem. Phys., 1987, vol. 6, no. 1, pp. 45-51; and V.M. Akimov, A.F. Rogozin, L.U. Rusin, "Molecular Beam Diagnostics of a Chemical Active Vacuum Arc Plasma.", Sov. Chem. Phys. 1986, vol. 5, no. 9, pp. 1243-1248) have suggested that the consistency of plasma flow might be controlled in an arc vapor deposition process by introducing reactive gas into the discharge process. However, any particulars as to how this might be effectively accomplished have not been shown. The effect of simply directing a flow of gas into and through the deposition chamber in a volume that might have a positive effect upon controlling the size distribution of macroparticles created at the cathode would necessarily increase the gas pressure in the vacuum chamber to such an extent that the deposition rate of such a system would be dramatically reduced. Another drawback of such a system would be that the increased gas pressure in the chamber would render ion bombardment surface conditioning of the substrate surface to be coated (which has been found to be a desirable technique for preparing the substrate surface for coating) impossible or very ineffective, due to the presence of the high background gas pressure.

U.S. Pat. No. 4,929,322 to Sue et al. suggests the control of inert gas introduced into the evacuated arc deposition chamber by surrounding the cathode with an elongated member having an open end, to form a "cathode chamber," and by directing a flow of gas through the cathode chamber. The reactive gas in the described system is introduced to the cathode chamber along the outer peripheral edges of the cathode such that concentration of the reactive gas is greater within the cathode chamber than in the rest of the deposition chamber. The stated purpose of this structure is to condition the arc in the cathode chamber, resulting in an increase of plasma pressure and temperature in such area so as to maximize confinement of the arc to the cathode evaporation surface for permitting continuous, stable, extended operation of the coating apparatus. This technique, while offering one reason for controlling the method of gas introduction to the system, however, does not address the issue of minimizing macroparticle generation at the cathode evaporation surface. The Sue technique suffers the same drawbacks of reduction in deposition rate and the reduced ability to condition the substrate surface by ion bombardment, as prior art techniques. A further disadvantage of the cathode chamber technique for controlling gas introduction to a deposition system is that since most macroparticles are ejected by cathode spots at an angle of incidence of from about 10 degrees to 30 degrees from the cathode surface, the elongated walls of the cathode chamber which project outwardly from the cathode surface may actually redirect generated macroparticles toward the substrate surface that would otherwise not reach the substrate.

The present invention provides a simple, yet effective way of simultaneously addressing the above-described needs in the art for reducing and eliminating macroparticle generation, and the shortcomings and deficiencies of known prior art techniques related to the formation, handling and elimination of macroparticles in electric arc vapor deposition processes.

## Summary of the Invention

The present invention provides an improved arc vapor deposition process and apparatus for practicing the process, that efficiently provides smooth dense deposited coatings at high deposition rates. The gas controlled arc deposition process of this invention selectively and accurately controls the introduction and flow of process gas introduced to the deposition system. According to one aspect of the invention, the process gas is introduced through the cathode evaporation surface. Such technique for introducing the process gas creates a "process gas activation region or zone" adjacent to the cathode evaporation surface. This created zone is located just above the Langmuir sheath where the cathode potential voltage drop occurs. Activation processes such as ionization and excitation of atoms or molecules and dissociation of the gas molecules of the introduced process gas takes place in the process gas activation zone. The thickness of the process gas activation zone is determined by the relative value of the cross-sections for elementary processes in the near electrodes plasma and by the concentrations of charged particles emitted from the cathode surface. The activation processes within the process gas activation zone occur primarily through the mechanisms of charge transfer from highly charged cathode material ions and by means of nonelastic collisions between plasma electrons accelerated in the Langmuir sheath and process gas atoms or molecules. Such activation processes thereby create a high level of ionized and excited gas species influencing the cathode spot formation and operation. The invention allows for the formation of emission-active phase compounds on the cathode surface, which influence the binding energy and decrease the electron work function of the materials, to minimize or eliminate the formation of thermal cathode spots on the cathode evaporation surface and the macroparticles created by such thermal cathode spots.

The process gas controlled arc process of this invention provides for controlled introduction of the process gas into the system where it is needed most, within that microscopic dimensional region adjacent the cathode evaporation surface, but does not significantly affect the overall gas pressure in the deposition chamber. This permits operation of the deposition system at low chamber pressures which prevents loss of charged and excited plasma particles due to recombination and disactivation as the plasma moves through the chamber from the cathode evaporation surface to the substrate, which allows for efficient, high deposition rates, effective ion bombardment conditioning of the substrate surface being coated and the application of dense, smooth, extremely hard coatings on the substrate. The present invention allows for effective conditioning of surfaces in the presence of gas species with minimum of macroparticle contribution thereby allowing use of this method for providing a cost-effective ion source which can be used for plasma substrate conditioning, gas implantation, gas nitriding, etc., applications. The present invention provides a simple and efficient technique for realizing a steady vacuum arc discharge at high deposition rates with low macroparticle generation by cathode spots. The process is applicable to the smooth, dense deposition of heretofore difficult to deposit coatings such as AlN and to the deposition of coatings from multiple cathode sources of different materials such as (TiAl)N, since process gas flow rates for the different cathode materials can be independently and accurately controlled. Such multiple cathode source deposition eliminates the need to use expensive composite cathodes such as those made using powder metallurgy technology.

According to one aspect of the invention, there is disclosed a method of enhancing plasma generated from a cathode evaporation surface of a sacrificial cathode by an electric arc in a vapor deposition chamber, comprising the step of selectively introducing a process gas into the deposition chamber at a predetermined flow rate to create a process gas activation zone for enhancing plasma activation adjacent to the cathode evaporation surface. According to a further aspect of the invention, the process gas is introduced through the cathode evaporation surface of the cathode. The process gas may also be introduced through one or more passageways formed through the cathode and the cathode evaporation surface, and the cathode may be formed at least in part of porous material defining capillary passageways therethrough through which the process gas passes on its way to the cathode evaporation surface. The invention contemplates operation of such method wherein the cathode is cooled for operation in either a cold regime mode or a hot regime mode. The cathode may be an electrically conductive material which includes metals, carbon or materials which become conductive as a function of doping or temperature. The process gas may be a reactive or nonreactive gas or any combination of the two gases or vapors. The process gas zone is located beyond the Langmuir sheath that occurs on the cathode evaporation surface during plasma generation, where the cathode voltage potential drop begins.

The process gas is activated within the process gas activation zone by transferring charge from highly charged ions of the cathode material, and/or by causing nonelastic collisions of plasma electrons with atoms and molecules of the plasma gas. The invention uses the process gas activation zone to reduce thermal cathode spot generation on the cathode evaporation surface, thereby reducing macroparticle introduction into the plasma. Creation of the process gas activation zone also enables formation of emission-active phase compounds on the cathode surface, thereby lowering the threshold of synthesis reaction on the cathode evaporation surface. The predetermined process gas flow rate which creates the process gas activation zone is a function of the type of material forming the cathode and of the type of process gas used, as well as a function of the discharge current of the arc and is greater than or equal to

$$I\left(\frac{Q_{cr}}{I_s}\right)^{\gamma}.$$

According to yet a further aspect of the invention, there is provided an electric arc vacuum deposition process comprising the steps of:

(a) operatively configuring an anode, a first sacrificial cathode source and a substrate within a vacuum deposition chamber;
(b) evacuating the chamber;
(c) introducing a first process gas into the chamber to create a first process gas activation zone adjacent to a cathode evaporation surface of the first cathode source;

(d) striking and maintaining an electric arc between the cathode evaporation surface of the first cathode and the anode, thereby vaporizing portions of the first cathode evaporation surface and creating a first plasma; and

(e) directing the first plasma into engagement with the substrate.

The directed plasma can be used to condition a surface of the substrate, to nitride the surface of the substrate or to form a coating of the plasma on the substrate surface. In such deposition process, the first process gas is preferably introduced through the cathode evaporation surface of the first cathode. According to yet a further aspect of the invention, the above deposition process includes configuring a second sacrificial cathode source relative to the anode and the substrate within the vacuum deposition chamber, introducing a second process gas into the chamber to create a second process gas activation zone adjacent to the cathode evaporation surface of the second cathode, and striking and maintaining an electric arc between the cathode evaporation surface of the second cathode and the anode to vaporize portions of the second cathode to create a second plasma.

According to yet another aspect of the invention, there is provided a method of creating a plasma in an electric arc vapor deposition chamber of the type having a sacrificial cathode source, comprising the steps of:

(a) operatively configuring an anode, a cathode source and a substrate within the deposition chamber;

(b) evacuating the deposition chamber to a first gas pressure;

(c) selectively introducing a process gas into the chamber through the cathode evaporation surface of the cathode at a predetermined flow rate;

(d) striking and maintaining an electric arc between the cathode evaporation surface and the anode, thereby creating a plasma from the cathode material and process gas; and

(e) directing the plasma toward the substrate.

The method includes the step of maintaining the average pressure within the deposition chamber at the first gas pressure, and provides for elimination of thermal cathode spot generation on the cathode evaporation surface.

According to yet a further aspect of the invention, there is provided a sacrificial cathode for use in electric arc vapor deposition, wherein an electric arc is struck between the cathode and an anode within a vapor deposition chamber, comprising: (a) a solid volume of source material configured to define at least one cathode evaporation surface to be struck by an arc; and (b) wherein the volume of source material defines a gas passageway formed through the source material and extending from an inlet end to an outlet end, wherein the outlet end opens through the cathode evaporation surface. Such source material may be electrically conductive material including metal, carbon, or materials which become conductive as a function of doping or temperature. Such materials may include, for example, metals such as titanium, nonmetals such as graphitic materials, or alloys. The source material may be appropriately shaped and may include shaped depressions surrounding the outlet end of the gas passageway in order to confine arc movement of the cathode spot(s) over the cathode evaporation surface. The cathode material may be configured entirely or partially from porous material beneath the cathode evaporation surface such that the process gas passes through the porous material and the cathode evaporation surface.

According to yet a further aspect of the invention, there is provided an electric arc vapor deposition system, comprising:

(a) a vacuum deposition chamber;

(b) an anode in or forming a part of the deposition chamber;

(c) a sacrificial cathode source of material in the deposition chamber, the cathode having a cathode evaporation surface;

(d) a substrate arranged and configured in the deposition chamber to receive plasma material from the evaporation surface of the cathode;

(e) means operatively connected with the deposition chamber for evacuating the chamber;

(f) power source operatively connecting the anode and the cathode for initiating and maintaining an arc between the cathode evaporation surface and the anode, thereby creating a plasma of source material; and

(g) a process gas delivery system operatively connected with the deposition chamber and the cathode for selectively delivering a process gas to the deposition chamber so as to form a process gas activation zone adjacent to the cathode evaporation surface.

While the present invention will be described with respect to several preferred embodiments which disclose and practice the principles of this invention, and with respect to certain types of source materials and gases used in implementing the described processes and apparatus, it will be understood by those skilled in the art that other apparatus gases and materials can be used within the scope of this invention. Further, it will be appreciated that the principles practiced by the methods of this invention can also be applied to or used in association with other known arc deposition techniques to further enhance arc deposition processes and the formation of coatings thereby. These and other aspects of the invention will be more fully appreciated from the following detailed description of the invention as applied to specific embodiments, examples and implementations.

## Brief Description of the Drawing

Referring to the Figures, wherein like numerals represent like parts throughout the several views:

Fig. 1 is a diagrammatic view of an electric arc physical vapor deposition system configuration which employs the principles of this invention;

Fig. 2 is an enlarged cross-sectional view of a first embodiment of the cathode and cooling support portions of the configuration of Fig. 1, illustrating the cathode as being operated in a cold mode;

Fig. 3 is an enlarged cross-sectional view of a second embodiment of the cathode and cooling support portions of the configuration of Fig. 1, illustrating the cathode as being operated in a hot mode;

Fig. 4 is an enlarged diagrammatic cross-sectional view of a third embodiment of a cathode configuration constructed according to the principles of this invention, illustrating a porous cathode configuration being operated in a cold mode;

Fig. 5a is a scanning electron micrograph representation of the surface morphology of a coating deposited according to the gas controlled arc process of this invention;

Fig. 5b is a scanning electron micrograph representation of the surface morphology of a coating deposited according to a conventional electric arc deposition process of the prior art;

Fig. 6a is a scanning electron micrograph representation of a fracture cross-section of the coating of Fig. 5a;

Fig. 6b is a scanning electron micrograph representation of a fracture cross-section of the coating of Fig. 5b;

Fig. 7 is an experimental results graph of the cathode erosion rate versus nitrogen flow rate for cathodes operating in a conventional arc deposition process as compared to those operating in a system configured according to the principles of this invention;

Fig. 8 is an experimental results graph of the process gas partial pressure within an arc deposition chamber versus the flow rate of the gas being introduced into the chamber for a conventional arc deposition process;

Fig. 9 is an experimental results graph of the process gas partial pressure within an arc deposition chamber versus the flow rate of the process gas being introduced into the chamber through the cathode for an arc deposition process practicing the principles of this invention;

Fig. 10 is an experimental results graph of discharge arc voltage drop versus process gas flow rate for a process practicing the principles of this invention;

Fig. 11 is an experimental results comparative graph of the relative intensity variations of titanium spectral line (TiI, $\lambda = 5210$ Å) as a function of nitrogen flow rate for cathodes operating in a conventional arc deposition process as compared to those operating in a system configured according to the principles of this invention;

Fig. 12 is an experimental results graph of the relative intensity variations of $N_2^+$ spectral line ($N_2II$, $\lambda = 3914$ Å) as a function of nitrogen flow rate for cathodes operating in a conventional arc deposition process as compared to those operating in a system configured according to the principles of this invention;

Fig. 13 is a scanning electron micrograph representation of the surface morphology of a cathode operating in a cold mode in a conventional arc deposition chamber with a process gas flow rate of 20 sccm;

Fig. 14 is a scanning electron micrograph representation of the surface morphology of a cathode operating in a hot mode in a conventional arc deposition chamber with a process gas flow rate of 20 sccm;

Fig. 15 is a scanning electron micrograph representation of the surface morphology of a cathode operating in a cold mode in a conventional arc deposition chamber with a process gas flow rate of 120 sccm;

Fig. 16 is a scanning electron micrograph representation of the surface morphology of a cathode configured according to the principles of this invention and operating in a cold mode with a process gas flow rate of 120 sccm;

Fig. 17 is a scanning electron micrograph representation of the surface morphology of a cathode configured according to the principles of this invention and operating in a cold mode with a process gas flow rate of 20 sccm; and

Fig. 18 is a scanning electron micrograph representation of the surface morphology of a cathode configured according to the principles of this invention and operating in a hot mode with a process gas flow rate of 20 sccm.

## Detailed Description of the Preferred Embodiment

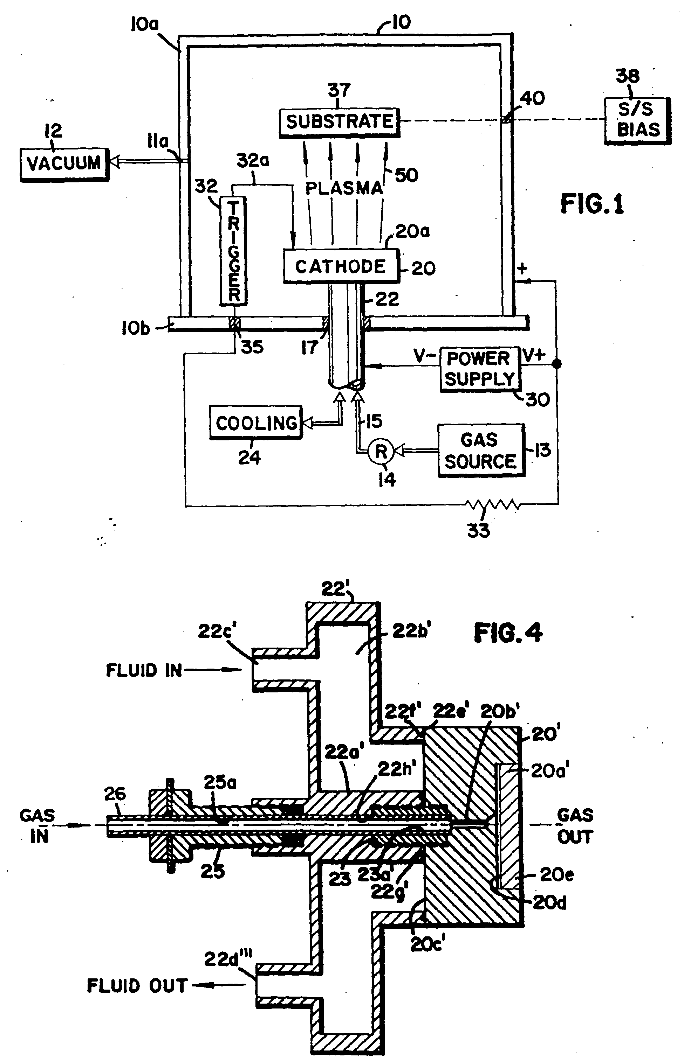

Referring to the Drawing, there is generally illustrated in Fig. 1, a diagrammatic representation of a typical conventional electric arc vapor vacuum deposition system with which the present invention can be used. It is emphasized that Fig. 1 is only a diagrammatic representation of such a deposition system, which generally schematically illustrates those basic portions of an electric arc vacuum vapor deposition system that are relevant to a discussion of the present invention. Those skilled in the art will readily recognize any missing elements and be able to complete the representation so as to provide a working system. For a more detailed description of electric arc vacuum vapor deposition systems and various portions thereof, one may refer to U.S. Pat. Nos. 3,793,179 to Sablev et al.; 4,485,759 to Brandolf; 4,448,799 to Bergman et al.; and 3,625,848 to Snaper. To the extent that such additional disclosure is necessary for an understanding of this invention, or to support the appended claims, the disclosures and teachings of such patents are herein incorporated by reference.

Referring to Fig. 1, there is generally illustrated at 10 a vapor vacuum deposition chamber having a first wall chamber portion 10a and a second wall chamber portion 10b appropriately connected together (not illustrated) to form an enclosed inner cavity 11 that defines a deposition chamber in which substrates are to be coated. A vacuum pumping system, diagrammatically illustrated at 12, communicates with the inner cavity 11 through an outlet port 11a of the cavity 11, and is operable to suitably evacuate the chamber in a manner well- known by those skilled in the art. Appropriate process gas source means for inserting reactive or inert process gases into the inner cavity 11 during the deposition procedure, are generally illustrated at 13, and communicate with the inner cavity 11 through a flow control regulating means generally indicated at 14 and a gas flow path 15 (to be described in more detail hereinafter).

A source of coating material 20, referred to in Fig. 1 as the "cathode" represents the origin of coating vapor or "plasma" for the vapor deposition coating process, and represents one electrode of an arc generating apparatus. In an electric arc vapor deposition system, such source of coating material generally represents a physical mass of coating material, in solid form. The physical shape of the source material can vary from cylindrical, to rectangular, to irregular in shape, as is well-known to those skilled in the art. The type of source material can also significantly vary, from conductive materials such as a metal or carbon to a material that becomes a conductor as a function of doping or temperature, such as boron, silicon or germanium, and also compounds and alloys of the same. In a preferred embodiment of the invention, the source material is preferably a conductive metal, and is preferably titanium. The source material 20 is mounted in the deposition cavity 11 by appropriate mounting means, generally illustrated at 22 in the Drawing, and typically has at least a portion thereof projecting outwardly through one of the chamber walls to the atmospheric environment. In the diagrammatic illustration of Fig. 1, the mounting means 22 is illustrated as projecting through the second chamber wall portion 10b. Due to the high electric current levels passing through the cathode during the electric arc vapor deposition process, the cathode gets extremely hot, requiring external cooling. Such cooling is typically provided by water flow through the system, the supply for which is schematically illustrated at 24 in Fig. 1, which communicates with the cathode mounting apparatus 22 by means of the fluid flow path 16. Appropriate vacuum sealing and electrical isolation means, generally illustrated at 17, are provided for maintaining the vacuum within the deposition cavity 11 and for electrically isolating the source 20 from the deposition chamber wall portions 10.

A primary power source for generating and maintaining the electric arc energy of the system is illustrated at 30. In the example illustrated, a DC power source is depicted with its negative terminal (V-) electrically connected to the cathode source 20, generally through the cathode mounting means 22. The positive terminal (V+) of the power supply 30 is directly connected to a primary anode of the electric arc system. While the anode may comprise a separate structure within the cavity 11, the chamber wall often acts as the anode, as is illustrated by the connection of the positive terminal (V+) to the chamber wall 10 in Fig. 1. While not illustrated in the figure, the anode may also be provided with appropriate cooling means, in manners well-known in the art. It will be appreciated that other than DC power supplies may be used.

The electric arc is typically initiated within the deposition chamber cavity 11 by means of a trigger assembly, generally indicated at 32. The trigger assembly 32 may be of any appropriate construction, such as for example the pneumatically operated trigger apparatus of U.S. Pat. No. 4,448,799, or of any other configuration that is operable to initiate an arc between the cathode source 20 and the anode 10. Such trigger assemblies typically include a movable contact rod member, generally indicated at 32a which is operable so as to move into and out of electrical contact with the cathode evaporation surface 20a. Electrical power for initiating an arc on the cathode surface 20a is provided to the trigger assembly 32 from the (V+) output terminal of the power supply 30, typically through a resistor 33 and an appropriate signal flow path such as indicated at 34. The signal flow path 34 passes through the chamber wall 10b by means of an insulating seal member, generally indicated at 35. Operation of the arc-initiating trigger apparatus and the general operation of the arc vacuum vapor deposition chamber is well-known in the art, and will not be further detailed herein.

Those items to be coated within the chamber 11 are typically referred to as substrates, and are diagrammatically illustrated at 37 in Fig. 1. The substrate(s) are appropriately mounted within the chamber, and may also be electrically biased, as diagrammatically illustrated by the substrate bias supply functional block 38, which is operatively connected to the substrate(s) by means of an appropriate signal flow path, generally indicated at 39. The substrate(s) can also be heated (or cooled) by appropriate heating (cooling) means (not illustrated). The signal flow path 39 is electrically isolated from the chamber wall 10a by appropriate electrical insulator and seal means, generally indicated at 40. It will be understood and appreciated that the relative spacings between and configurations for components such as the cathode, anode and substrate(s) in Fig. 1 are diagrammatic in nature, and are not intended to be represented to scale or as they would actually appear relative to one another in an operative system.

The electric arc(s) created and sustained between the cathode evaporation surface 20a and the anode (inner walls of the deposition chamber 10) create a plasma 50 which is outwardly directed from the cathode evaporation surface 20a for engagement with and generally for coating the substrate 37 or selected portions thereof, as is well-known in the art. Such plasma 50 includes neutral atoms, molecules of residual or reactive gas introduced into the chamber 11, and ionized atoms and molecules. In conventional arc vacuum deposition processes, the arc(s) also generate a large amount of macroparticles. Compound coatings are created by introducing reactive gases into the chamber from the reactive gas source 13, which gases combine with vaporized material from the cathode source 20.

The arc terminus or attachment spot which is visible on the cathode evaporation surface 20a is typically referred to as a "cathode spot." One or more such cathode spots may exist on the cathode surface at a time, depending upon the level of current in the arc. The size or radius of such spots vary with the type of source material and the energy present in the arc. Numerous observations of such cathode spots have led to the discovery that the cathode spot terminology actually refers to several significantly different types of spots (see for example A. Parfenov, "Concerning the Types of Cathode Spots," IEEE Transactions on Plasma Science, vol. PS-13, No. 5, 1985.) The observed cathode spots are generally divisible into two types: "explosive" spots and "thermal" spots. Explosive spots represent cyclical operation of explosive emission centers which leave characteristic traces on the cathode surface which are microcraters of micrometer or submicrometer size. Thermal cathode spots differ in essence from explosive cathode spots. The thermal spots appear only in a period of time after the arc discharge has started, and they occur only in those sites where explosive spots have been operating until that moment. The thermal spots produce the strongest cathode erosion and represent the largest source of undesirable macroparticle generation. In accordance with the present invention, it has been discovered that the plasma may be enhanced for conditioning of substrates and the deposition of coatings by introducing a process gas into the deposition system in a controlled and unique manner. By such selective and precise control of the process gas introduction to the system, the present invention enables the prevention of formation of slow moving thermal spots even at very high discharge currents (i.e., about 300 amps) and at very low process gas flow rates. By thus preventing, or at least minimizing, the formation of thermal spots on the cathode evaporation surface, macroparticle generation can be minimized and virtually eliminated, even in line-of-sight cathode/substrate configurations, thereby providing deposition of smooth and dense coatings on the substrate 37.

The present invention significantly differs from deposition structures of the prior art such as that of U.S. Pat. No. 4,929,322 described in the Background section of the specification, which introduced gases into a "cathode chamber" formed above the cathode evaporation surface. Such prior art configuration does not adequately provide for the introduction and maintenance of process gas at the cathode evaporation surface, where it is most needed during the vaporization process in order to prevent the formation of thermal cathode spots on the cathode evaporation surface and does not create a process gas activation zone as defined herein, or provide the other process advantages offered by this invention.

The arc energy passing through a cathode spot and into the cathode through the cathode evaporation surface, transforms a portion of the solid cathode material into a "plasma jet" of material that is forcibly ejected into the vacuum chamber above the cathode evaporation surface as a part of the coating plasma. Prior art techniques of reactive or process gas introduction into the vacuum chamber, even that such as illustrated in the 4,929,322 patent, have not been able to effectively force the gas "down" to the cathode evaporation surface since the plasma jets in effect create a pressure wave which forces the introduced gases of prior art structures up and away from the cathode evaporation surface. In contrast, the present invention ensures that there will be adequate process gas molecule concentration at the location where it is most needed, on and immediately above the cathode evaporation surface. According to a preferred embodiment of this invention, a process gas is introduced into the deposition system through the cathode evaporation surface, thereby ensuring relatively high process gas molecule concentration at the cathode evaporation surface. The gas introduction process of this invention creates a process gas activation region or zone adjacent to the cathode evaporation surface, thereby creating a high level of ionized and excited gas species which influences the cathode spot formation and operations. The process gas activation zone is located just beyond (as measured in a direction away from and normal to the cathode evaporation surface) the Langmuir sheath where the cathode potential voltage drop occurs. For a more thorough discussion of the Langmuir sheath phenomenon, the reader is referred to: G.A. Lubimov and V.I. Rakhovskii, "The Cathode Spot of a Vacuum Arc", Sov. Phys. Usp. 21(8), Aug. 1978. Activation processes such as ionization and excitation of atoms or molecules and dissociation of the process gas molecules takes place in the process gas activation zone created by this invention.

The thickness of the process gas activation, zone is determined by the relative value of the cross-sections for elementary processes in the near electrode plasma and by the concentrations of charged particles emitted from the cathode surface. The thickness of the activation zone is equal to:

$$h \leq \max(l_i, l_e) \qquad \text{Eqn. 1}$$

where $l_i$, $l_e$, are the mean free paths of the cathode material ions and electrons in the process gas. These mean free paths may be determined as:

$$l_{i,e} = 1/n_g \sigma_{i,e} \qquad \text{Eqn. 2}$$

where $n_g$ is the concentration of gas atoms or molecules, $\sigma_{i,e}$ is the cross-section of the process.

As seen from the definition of the thickness of the activation zone, its magnitude depends on the specific combination of the cathode material and the type of process gas. It should be noted that the process gas can be inert such as Ar, Kr, Xe or reactive such as $O_2$, $N_2$, $H_2$, or gas compounds such as $CH_4$, $C_2H_2$, etc. In addition, the process gas can be combinations or partial pressures of the above.

It is necessary to note that the length of the process gas activation zone is several orders greater than thickness of the space-charged layer (Langmuir sheath) which is estimated as $\gamma \leq \min(l_i, l_e, l_{em})$, where $l_i$, $l_e$, $l_{em}$ are the mean free paths of the cathode material ions and electrons of the plasma and of the emitted electrons, respectively. The concentration of the cathode material atoms is of the order of $10^{19}$-$10^{20}$ cm$^{-3}$ whereas the concentration of process gas even in the case of process gas controlled arc is about $10^{16}$-$10^{17}$ cm$^{-3}$ (an additional source of gas molecules in this zone is the desorption of the process gas from the cathode working surface due to the cathode spots operation). In addition, cross-sections for elementary processes (ionization for example) for cathode materials as a rule is more than for process gases. So the space-charged layer is negligibly small compared to the process gas activation zone. In this case, the thickness of this zone may be measured from the cathode working surface.

This analysis demonstrates one of the main advantages of this technique in that it allows for operation of the cathode at high local gas concentration while depositing the coating at low gas pressure in the chamber. This increases the concentration of the gas molecules in the process gas activation zone to $10^{16}$-$10^{17}$ cm$^{-3}$ which is two orders of magnitude greater than the concentration of gas molecules in the near cathode region in the case of the conventional process.

The processes of ionization and excitation of the process gas molecules and atoms in the process gas activation zone occur by way of many mechanisms, but occur primarily through the mechanisms of charge transfer from highly charged cathode material atoms and by means of nonelastic collisions between plasma electrons accelerated in the Langmuir sheath, and process gas atoms or molecules (as described more fully below). The performance of any particular activation mechanism depends on the specific combination of the cathode material and on the type of process gas or gas mixture being used. The process gas activation zone also allows for the formation of emission-active phase compounds on the cathode evaporation surface, which influence the binding energy and decrease the electron work function of the materials, to minimize or eliminate the formation of thermal cathode spots on the cathode evaporation surface and the macroparticles they create. As will be appreciated from the following descriptions and examples practicing this invention, the unique method for introduction of process gas into the system and creation of the plasma gas activation zone provides for the creation of coating and cleaning plasmas that produce deposited coatings with superior quality over known prior art coatings and also facilitates the processing steps required to fabricate such coatings. For example, the deposition process can be achieved at relatively low chamber gas pressure, making effective plasma conditioning of a substrate possible and which is further enhanced by the types of energized plasmas that can be created by use of this invention. This invention further provides for extremely stable arc operation in a steady-state regime with very low discharge current and for the deposition of previously difficult to deposit source materials.

As previously stated, activation of the process gas within the process gas activation zone is accomplished through many mechanisms. One of the primary such mechanisms for process gas activation takes place due to charge transfer from highly charged ions such as shown in the following equations:

$$M^{z^2} + G \rightarrow M^{(z-1)^+} + G^+ \qquad \text{Eqn. 3}$$

where M is an ion of the cathode materials, G is the process gas atom or molecule, and z is the ion charge. These reactions are the most effective due to high process gas atom or molecule concentration just near the cathode surface. This reduces the content of highly charged ions in the plasma flux and increases the process gas ionization level.

A second important mechanism of process gas activation is by means of nonelastic collisions between plasma electrons accelerated in the Langmuir sheath, and process gas atoms and molecules.

The probability $W_e$ of the interaction of plasma electrons with reactive gas atoms or molecules can be written as:

$$W_e \sim \Sigma\, n_e n_g < \sigma_e (V_e) > \qquad\qquad\qquad \text{Eqn. 4}$$

where $n_e$ is the average electron density or concentration in the process gas activation zone, $n_g$ is the concentration of process gas atoms or molecules in the same zone, $\sigma_e(V_e)$ is the cross-section for the specific process, $V_e$ is the relative velocity of electron and gas atom or molecule, and $< >$ denotes averaging over the distribution function. Summation is carried out over all forms of inelastic interactions.

As is evident from Eqn. 4, an increase in process gas concentration near the cathode surface is accompanied by a significant increase in the degree of excitation, dissociation, and ionization of the process gas molecules, which sharply lowers the threshold of the nitride (carbide, oxide, etc.) synthesis reaction and the growth of the nitrogen (carbon, oxygen and s.o.) content in the coatings. Therefore, the interrelated influence exerted on the state of the reactive gas by the interaction processes of the electron and ion components of the plasma with gas added through the cathode, leads to an avalanche-like increase in the degree of activation of the reactive gas, rapidly developing into saturation as the result of the practically complete dissociation and ionization of the gas. While such gas activation processes are present to some extent in conventional arc processes, they are very inefficient in such prior art systems. However, by introducing the processing gas into the system as shown in this invention, the degree of processing gas activation is dramatically enhanced. Further, the possibility of running the deposition process at low gas pressure in the vacuum chamber helps to avoid loss of the charged and excited particles created in the process gas activation zone, that might otherwise occur (as in prior art systems) by recombination or disactivation of the charged particles as they progress through the prior art process gas present in the chamber from the cathode evaporation surface to the substrate. Accordingly, this invention provides significant advantages over conventional prior art arc deposition processes in that it provides for high level of activation of the process gas species in the process gas activation zone, and such energized gas species are able to effectively reach the substrate due to comparatively low gas pressures in the vacuum chamber.

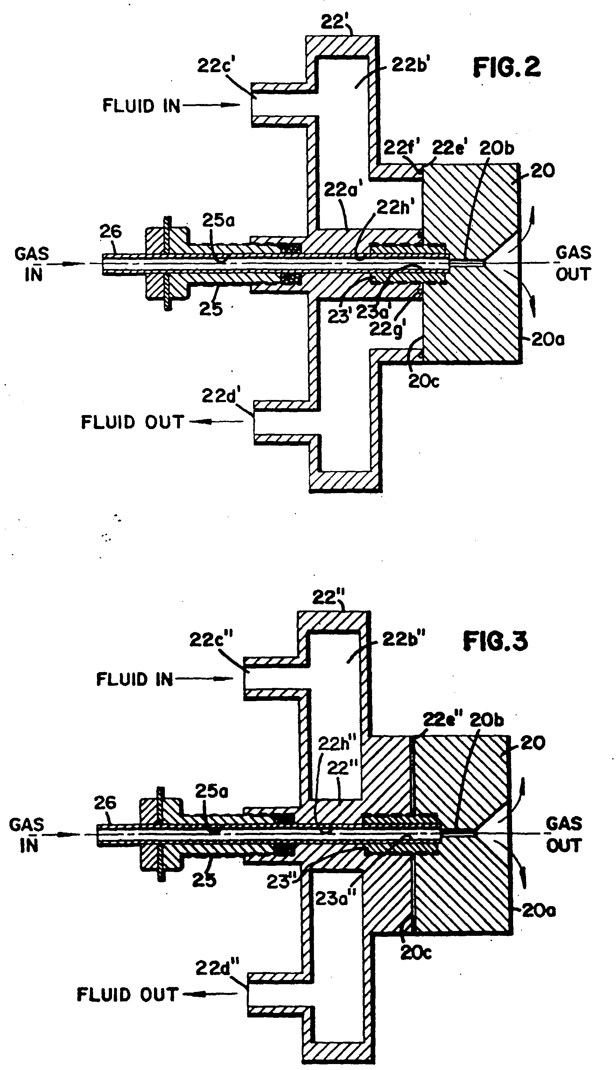

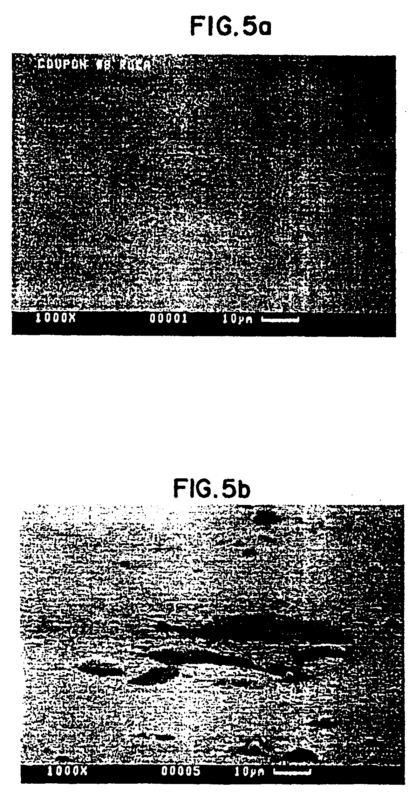

The physical implementation of the process gas injection through the cathode proper of this invention may be achieved by various methods. One means of achieving such gas injection through the cathode may be accomplished by manufacturing the cathode material entirely or partially from a "porous metal" such as illustrated in Fig. 4, wherein the injected gas permeates under pressure through a system of capillary canals formed by interconnecting porosity of a portion of the cathode. Such materials typically referred to in the art as "porous materials" are commercially available from such companies as Astro Met, Inc., which market such materials under the AMPORMAT trade name. Such materials include metals and alloys as well as ceramics and oxides and can be configured to virtually any porosity/density desired as for example from porosities ranging from 15% to 95%. Alternatively, the reactive gas may be injected through one or a plurality of holes formed or drilled through the cathode or through a system of holes drilled through or formed into the cathode, such as illustrated in Figs. 2 and 3. Referring to Figs. 2 and 3, the cathode 20 has a single gas injection passageway 20b axially formed therethrough and extending from the cathode evaporation surface 20a and through the material forming the cathode body, to and through the rear surface 20c of the cathode. In the configurations illustrated in Figs. 2 and 3, the cathode evaporation surface 20a defines an axially aligned conically shaped depression that cooperatively and continuously unites with the passageway 20b such that process gas injected through the passageway 20b uniformly continuously flows over and in direct engagement with the entire cathode evaporation surface 20a, thus providing an adequate process gas molecule concentration in the interface between the cathode working surface and the plasma jets generated by the cathode spots (as generally indicated by the gas flow lines in Figs. 2 and 3).

The cathode surface temperature may be considered as a factor which determines the reaction rate of the erosion-reducing layer formation since the kinetics of surface reactions strongly depend on the cathode surface temperature. Therefore, according to two different embodiments of the invention, the described cathode is mounted for operation on two different types of cooling structures for operation in two modes: "cold" (direct cooled cathode as illustrated in Fig. 2) and "hot" (indirect cooled cathode as indicated in Fig. 3). In the case of the "hot" cathode mode of operation, the cathode's crystalline structure transformation must be taken into account as well as the cathode's surface temperature distribution in the influence it has on the cathode spot motion.

Referring to Fig. 2, the cathode 20 is illustrated as secured to the mounting means 22' for operation in the "cold" mode. The mounting means 22' has a central spindle 22a' into which is threaded one portion of a stud member 23'. The mounting member 22' is hollowed out to define an annular fluid passageway 22b' having inlet and outlet ports 22c' and 22d' respectively that are cooperatively connected in fluid communication with the fluid flow path 16 (Fig. 1) to the primary cooling source means 24. That portion of the annular fluid passageway 22b' which addresses the "back" surface 20c of the cathode 20 is open and provides direct fluid flow engagement with the back surface 20c of the cathode 20. In the preferred embodiments illustrated in Figs. 2 and 3, the cooling fluid is preferably water. The stud member 23' is threaded into the cathode 20 through its back side 20c as illustrated in Fig. 2 such that the back surface 20c of the cathode 20 forms a tight seal with the annular outer edge of the mounting means 22e' and the corresponding upper surface of the central spindle 22a'. The seal for the annular fluid passageway 22b' is closed and maintained with the lower surface of the cathode 20c by means of a pair of O-rings 22f' and 22g'.

A lower stud member 25 defining an internal axial passageway 25a is threaded into the lower portion of the central spindle 22a' to form an axial extension thereof. The central spindle 22a' defines a central axially aligned passageway 22h', and the threaded stud member 23' also defines an axial passageway 23a' formed therethrough. The axial passageways 25a', 22h' and 23a' are commonly sized and aligned so as to provide a continuous fluid flow passageway from the lower portion of the lower stud member 25 to the fluid passageway 20b formed in the cathode 20. A cylindrical sleeve member 26 is secured within the common passageway defined by 25a', 22h' and 23a', as indicated in Fig. 1, to provide a sealed gas flow passageway through the lower stud member 25, the central spindle 22a' and the upper stud 23. The sleeve member 26 is connected in fluid communication with the fluid flow line 15 (Fig. 1) to receive a pressurized supply of process gas from the primary gas supply means 13.

A preferred configuration for mounting the cathode 20 for operation in a hot mode, is illustrated in Fig. 3. Referring thereto, the configuration is very similar to that of the cold mode mounting configuration of Fig. 2, except for the fact that the lower surface 20c of the cathode is not in direct fluid communication with the cooling source fluid, and thermal contact of the cathode with the cathode holder is minimized. In the hot mode cathode holder configuration illustrated in Fig. 3, the upper surface of the annular fluid passageway 22b" is completely closed by the lateral extension of the central spindle 22a" as indicated. In this cathode mounting configuration, the entire upper surface 22e" of the central spindle 22a" forms a seat for the lower surface 20c of the cathode 20 and provides cooling thermal transfer to the cathode through the material of the enlarged central spindle 22a", which in turn is in fluid communication with the cooling fluid passing through the annular fluid passageway 22b". In other respects, the cathode mounting structure of the hot mode mounting configuration of Fig. 3 is the same as that previously described with respect to the cold mode mounting configuration of Fig. 2. The lower surface 20c of the cathode 20 may be threaded down by means of the stud 23" into direct engagement with the upper surface 22e' of the central spindle 22a", or may be slightly axially spaced therefrom as is illustrated in Fig. 3.

In the case where the cathode or portion thereof is manufactured from a porous material such that the process gas can be directly injected through the capillary canals formed through the cathode material itself, the cathode mounting configuration could include a sealed manifold in direct fluid communication with the back surface 20c of the cathode, wherein the manifold is also in direct fluid communication with the gas supply line 15 leading to the primary process gas supply 13. Alternatively, the cathode may be configured to provide the gas distributing manifold 20d as illustrated in Fig. 4 wherein an insert of porous cathode material 20e is configured to cooperatively overlie the manifold portion 20d such that process gas introduced into the manifold 20d through the sleeve 26 and passageway 20b' flows through the capillary canals of the porous insert material to and through the upper cathode evaporation surface 20a' which is formed on the surface of the porous, cathode material.

The apparatus and methods of this invention, therefore, suggest a new technique for reducing macroparticles, for increasing the deposition rate, for simplifying the coating process and for improving the quality of the deposited coating. The method of this invention has been coined by the inventors as the "Gas-Controlled Arc" process, or the GCA process. This method is based in part on the creation of emission-active phases on the cathode surface and changing the character of a cathode spot's motion by changing the melting point of surface layers of the cathode's material and its work function. The process gas used can be reactive, nonreactive, or a combination of such gases or vapors, depending upon the material being deposited. For example, process gases such as nitrogen, argon, oxygen, hydrogen, hydrocarbons, krypton, xenon, etc., could be used. By way of example, the present invention is realizable in a reactive arc deposition process in which reactive gases are added to a vacuum chamber for synthesis combinations of the reactive gases with transition metals. It is known that depending on dimensions, properties and quantity, microroughness and various inclusions on the cathode surface may help to increase the rate of cathode spot migration, and may also help localize them to become confined to a definite part of the cathode surface. Different regimes of arc burning may occur depending on the dimensions of emission-active phase inclusions, and their quantity. For example, during deposition of titanium nitride and other complex coatings (such as oxides, carbides, oxi-carbo-nitrites of transition metals), formation of these emission-active phases on cathode surfaces has been found. A work function of titanium nitride (TiN) is 2.92 eV, as compared with a work function of 3.95 eV for pure Ti. The melting point for TiN is 2700° C; whereas for Ti, the melting point is only 1600° C. Therefore, by the formation of films on the cathode surface, it is possible to increase the binding energy and decrease the electron work function - and in so doing, change the type of cathode spots which exist on the evaporation surface of the cathode.

The present invention actually creates a film of an emission-active phase (TiN in the case of a titanium cathode and nitrogen process gas) on the cathode surface, thereby reducing the erosion of cathode material,. This is made possible by the presence of a rather high concentration of process gas in the process gas activation zone during the deposition process (about 5-10 mTorr). Such selective "poisoning" of the cathode surface, only in the process gas activation zone, while maintaining the process gas pressure in the remainder of the deposition chamber at a low value, has not been possible with the use of prior art arc deposition techniques. It is known, for example, that a titanium cathode surface will poison in the presence of a reactive gas such as nitrogen at a pressure of about 5-10 mTorr. It is well-known that such poisoning is also dependent upon other parameters, such as working surface area and cathode current. But such high gas pressure, if extended to the entire deposition chamber, as would be required of prior art techniques, critically decreases the deposition rate. Such high gas pressure throughout the chamber also makes ion bombardment of the substrate surface in the presence of the process gas all the more impossible due to increased collisions with the process gas atoms between the cathode and substrate, and oxygen contamination and arcing on the substrate surface. Accordingly, such prior art techniques attempting cathode poisoning and subsequent coating of substrates have led to inconsistent coating quality. The present invention allows for the selective introduction of a large process gas concentration only "at" and immediately adjacent the cathode evaporation surface (i.e., only in the process gas activation zone), and for rather low gas pressures throughout the rest of the vacuum chamber, and particularly between the cathode and substrate surface to be coated. According to a preferred embodiment of the invention, this is accomplished by injecting the process gas "through" the cathode, such that it actually flows through the cathode surface.

It is important, to ensure an adequate supply of process gas flow through the cathode surface. It is well-known that cathode spots generate very dense plasma jets, which prevent process gas diffusion (according to prior art methods) back toward the cathode surface region from the deposition chamber. These dense plasma jets work like "plasma pistons" which normally pump process gases introduced into a deposition chamber away from the cathode surface region. The present invention overcomes this shortcoming of prior art systems. In the present invention, the process gas flow rate required in the process gas activation zone is determined as a function of the arc discharge current, according to the following relationship:

$$Q/I \geq \left( \frac{Q_{cr}}{I_s} \right)^{\gamma} = \Lambda \qquad \text{Eqn. 5}$$

where Q is the flow rate in sccm, I is the arc discharge current in amperes, $Q_{cr}$ is the critical value of process gas flow rate for standard arc discharge current of 100 amperes, $I_s$ is the standard discharge current and $\gamma$ is a parametric factor related to a current range. For titanium, and an ion current range of up to 250 amps, $\gamma$ may be accepted as 1. For wider range of different materials and different current levels, $\gamma$ would have to be adjusted appropriately as is well-known by those skilled in the art. The magnitude of the constant $\Lambda$ depends on a combination of cathode material and the type of process gas. In a case of a titanium cathode and nitrogen, $\Lambda$ equals O.2. The fulfillment of this condition assures the appropriate type of cathode spots on the cathode evaporation surface, and therefore a proper coating smoothness. The critical flow rate is the process gas flow which provides effective cathode surface poisoning at any value of chamber evacuation pumping speed, while evacuating or pumping gas from the vacuum chamber, to maintain a predetermined pressure within the vacuum chamber (outside of the process gas activation zone).

In the cathode configurations practicing this invention such as shown in Figs. 2 and 3, wherein the process gas is introduced through a channel in the cathode, the cross-sectional diameter of the process gas flow channel in the cathode that would be required to deliver adequate gas flow to accomplish the purposes of this invention is defined by Equation 6:

$$Re = (4mQ) / (\pi K \mu TD) \qquad \text{Eqn. 6}$$

wherein Re is the Reynolds number, m is the mass of the molecule, $\mu$ is the viscosity of the gas, Q is the gas flow rate, K is the Boltzman's constant, T is the gas temperature, and D is the diameter of the gas inlet channel (where all parameters are given in international units).

A more complete appreciation of the principles of this invention will be apparent from a review of the following experimental tests that were performed practicing the GCA process of this invention.

<u>Comparative Coating Properties</u>

A comparison investigation of the coating properties achieved using the inventive GCA process and a regular or conventional arc process was conducted, with a comparative evaluation of the following properties: coating smoothness, deposition rate, microhardness and adhesion. To compare the two processes, and to elucidate the advantages of the GCA process over the conventional arc process, the titanium-nitrogen (Ti - $N_2$) system which is well understood, was used as a comparative system. The process gas flow and arc current were the same for both the GCA and the conventional processes. The GCA process was realized in two operational modes - with the "cold" and the "hot" cathode regimes. TiN coatings were deposited onto HSS coupons with the same deposition conditions but with the different deposition techniques. The only difference between them was in the way the $N_2$ process gas was introduced into the system. For the GCA process, the process gas was introduced through an inlet placed in the middle of the cathode working surface, as indicated in Figs. 2 and 3 for the "cold" cathode and "hot" cathode regimes respectively. For the conventional process, the process gas was introduced to the vacuum chamber through an inlet in a wall adjacent to the cathodic system as has been typically done in prior art systems. The results of these experiments are presented in Table 1.

Table 1

| | CONVENTIONAL ARC PROCESS | GCA PROCESS | |
|---|---|---|---|
| | | ** "COLD" CATHODE | *** "HOT" CATHODE |
| FILM ROUGHNESS, RA, Å | 540-850 | 160-170 | 160-240 |
| DEPOSITION RATE, μm/min | 0.06* | 0.2 | 0.3 |
| MICRO HARDNESS, $H_v$, N/mm$^2$ | 2800-2900 | 3900-3950 | 4000-4050 |
| SCRATCH TEXT, U.C.L., N | 75-80 | 75-85 | 85-90 |

* Deposition process was carried out at a nitrogen pressure of about 10 mTorr in the vacuum chamber. This regime was chosen to provide high quality coatings using prior art techniques, which minimized coating roughness (850A) and to provide high coating microhardness (2800-2900 N/mm$^2$).

** The integral cathode surface temperature during the deposition process was between 600-650°C.

*** The integral cathode surface temperature during the deposition process was between 1600-1800°C.

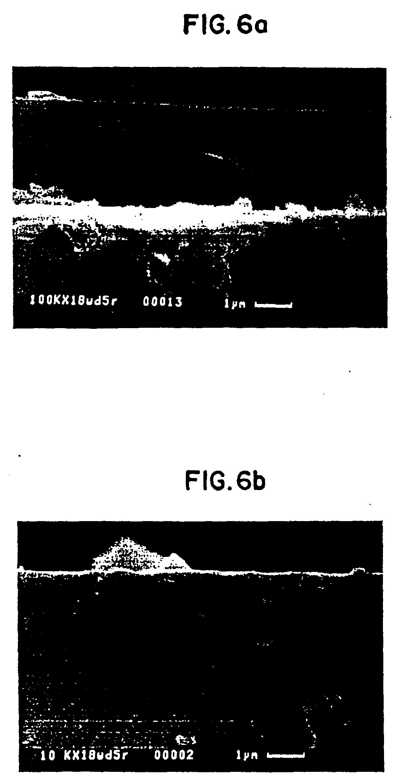

Figures 5a and 5b illustrate scanning electron micrographs taken respectively of the surfaces of the coatings produced above according to the GCA arc process and the conventional arc deposition process. As can be readily observed from the illustrations, the GCA process produced coating surface (Fig. 5a) does not have the large defects (correlating with the roughness measurements of Table 1) or the "ripple" effects visible on the coating surface (Fig. 5b) produced by conventional arc deposition techniques. Similarly, scanning electron micrographs from fracture cross-sections of the coatings produced by the GCA and conventional arc processes (Figs. 6a and 6b respectively) illustrate the improved surface characteristics produced by the GCA process. It should be noted that the results produced in these experimental tests were conducted in line-of-sight configurations between the cathode evaporation surface and the substrate, and without the use of any magnetic fields, and that even better results might be obtained by combining the principles of this invention with other known coating enhancement techniques.

As is evident from Table 1, the coating properties are superior for both of the GCA (hot and cold cathode regimes) processes over those of the prior art conventional arc technique. The results are sufficient to allow a definite conclusion that in the case of the inventive GCA process, the generation of macroparticles is significantly reduced and improved coatings are possible as compared to the regular or conventional arc deposition process.

Erosion Rate Measurements

It is known that the erosion rate for cathode degradation during the arc deposition process is defined as the relationship between the change in a cathode's mass according to the amount of conducted charge, as shown in Equation 7:

$$\Delta m = \kappa I \Delta t \qquad\qquad \text{Eqn. 7}$$

where m is the mass of the cathode, $\kappa$ is the erosion rate, I is the arc current and t is time.

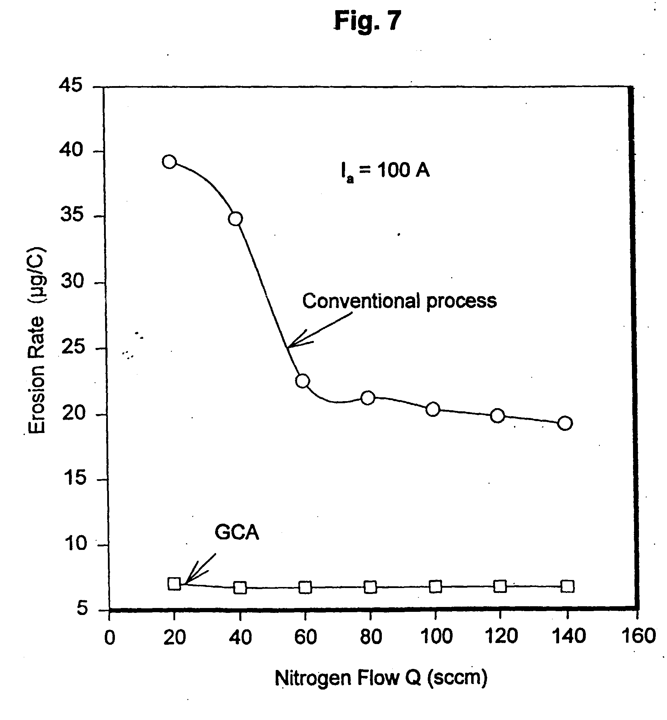

In order to determine optimum process gas flow, the gas flow was varied from 15 sccm to 160 sccm. Tests were conducted for both the GCA process and for the conventional arc deposition process. In each test, the steady state process gas pressure corresponding to the value of the gas flow was monitored by a vacuum meter. The measurements were performed by determining the mass of the Ti cathode before and after evaporation for 30 minutes at an arc current of 100 amps. The results of this testing is illustrated in Fig. 7 which shows the erosion rate versus the nitrogen process gas flow curves for both the conventional arc deposition and the GCA processes. This graph emphasizes dramatic difference between the two processes.

Comparative Gas Pressure vs. Flow Rate

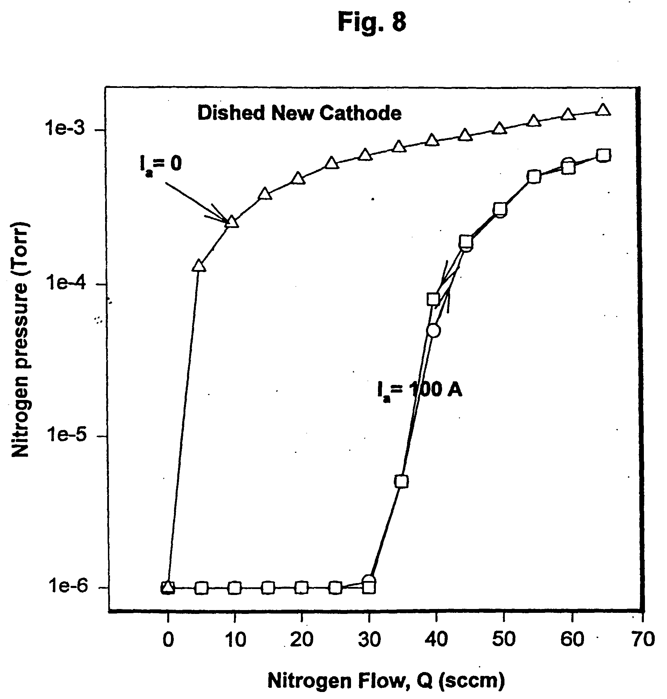

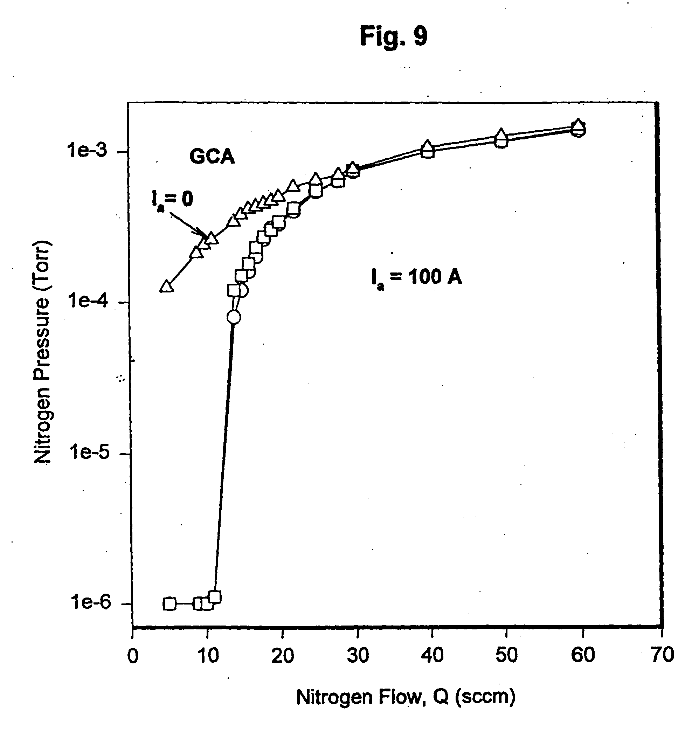

The relationship between the nitrogen process gas pressure and the $N_2$ flow rate for a 100 amp discharge current was tested for both the conventional arc deposition process and for the GCA process. The resulting curves are plotted in Fig. 8 for the conventional arc deposition process using a new dished cathode, and in Fig. 9 for the GCA process. In Fig. 8, the gas is being introduced to the chamber int he conventional manner; whereas in Fig. 9, the process gas is being introduced into the system through the cathode, as previously described. In Figs. 8-10 the "O" designations represent plots of the experimental results as process gas is being introduced to the system to increase the pressure; whereas the "□" designations represent plots of the experimental results as gas is being withdrawn from the system to reduce pressure. A comparison of the results of the Figs. 8 and 9 plots illustrates the fact that in the case of the GCA process, the formation of a TiN layer on the cathode surface occurs at a lower flow rate. Variation of the pumping speed by means of a throttle showed that there was not a significant difference in cathode erosion rate when gas flow rate Q $\geq Q_{cr}$, where $Q_{cr}$ is the critical flow rate from Equation 4. This demonstrates that due to the process gas introduction through the cathode surface, even a low gas flow rate provides the needed concentration of gas molecules in the interface between the cathode surface and the quasineutral plasma (i.e., in the process gas activation zone). Therefore, with the inventive GCA process, process gas flow is not a limiting factor for the desired chemical reaction to occur on the cathode surface.

Surface Morchology Comparisons

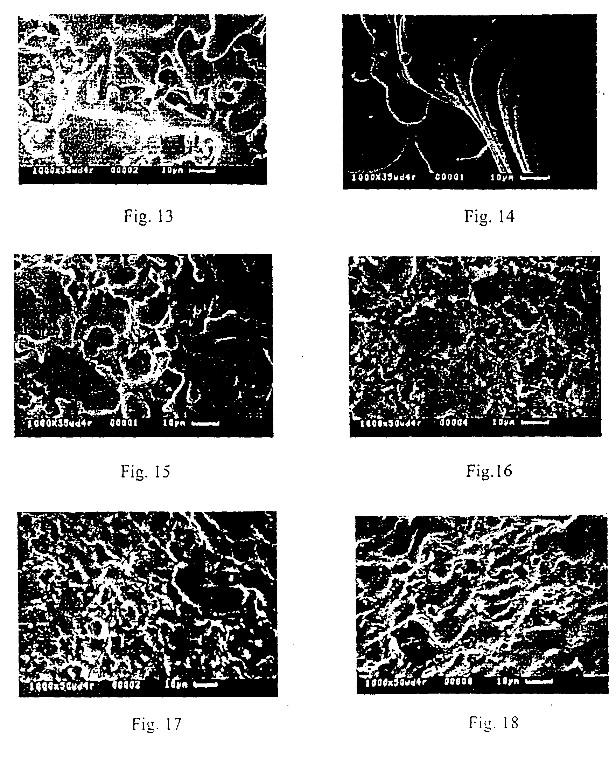

In this regard, it is interesting to compare scanning electron micrographs of surface morphologies of the cathodes that were used in the above testing with different process gas flow rates. The surface morphology photographs of these cathodes are illustrated in Figs. 13 through 18. Figs. 13 and 14 are photographs of the surfaces of conventional cathodes that operated in cold and hot modes respectively for process gas flow rates of 20 sccm. Fig. 15 is a photograph of the conventional cathode that operated in a cold mode at a gas flow rate of 120 sccm. Figs. 16 and 17 are photographs of the surface morphology of cathodes configured according to the principles of this invention that operated according to the GCA process in a cold mode regime for process gas flow rates of 120 sccm and 20 sccm respectively. Fig. 18 is a photograph of a cathode operated according to in the GCA process in a hot mode regime with a process gas flow rate of 20 sccm. Film composition, including nitrogen concentration, was determined by EDX in the scanning electron microscope. The results of analyses show that the titanium nitride layer is about stoichiometric within the accuracy of the measurements (5%). The surface morphology photographs are interesting in illustrating that even at flow rates of 20 sccm, the cathode surface of a cathode used in the GCA process (Fig. 17) is not melted to the degree of the cathode used in the conventional arc deposition process (Fig. 13).

Measured Discharge Arc Voltage Drop vs. Gas Flow Rate

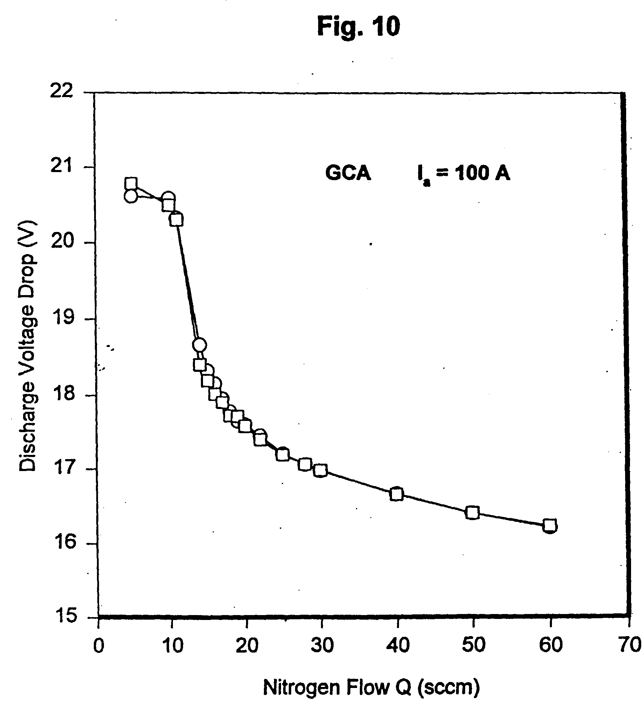

The process of formation of a layer on the cathode surface with a low work function and higher melting point (which can be referred to as the "erosion-reduction layer") was monitored by measuring the discharge arc voltage drop in the GCA system. The discharge arc voltage drop for the titanium cathode GCA process system was measured as a function of the nitrogen flow. These results are graphically illustrated in Fig. 10. The results show that the discharge arc voltage drop is very sensitive to the presence of the erosion-prevention layer, and may be used for process control and diagnostics. The results show that the GCA process has a very high affinity for the formation of the erosion-prevention layer. The erosion-prevention layer forms at very low process gas flow rates, and gives rise to the possibility of running the deposition process at very low input gas pressure, thereby reducing macroparticle generation at the same time as improving the deposition rate.

Spectral Measurement Comparisons

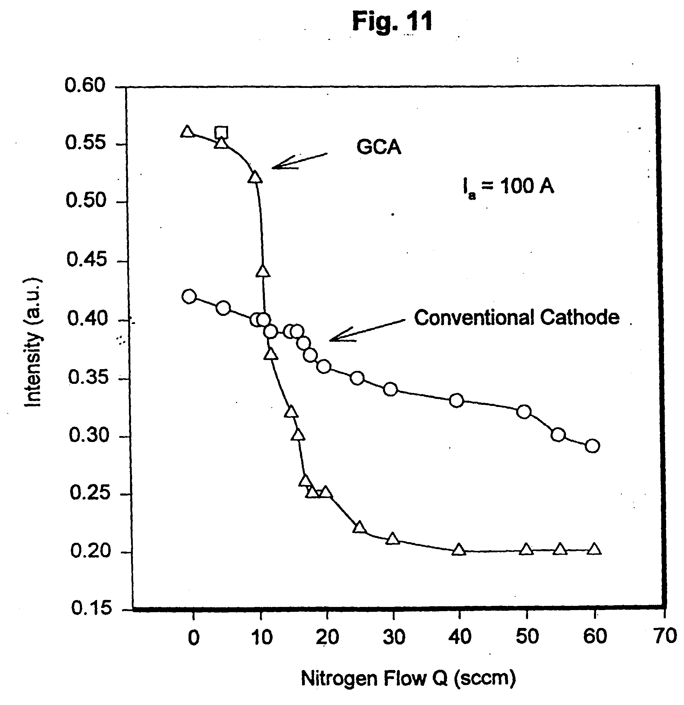

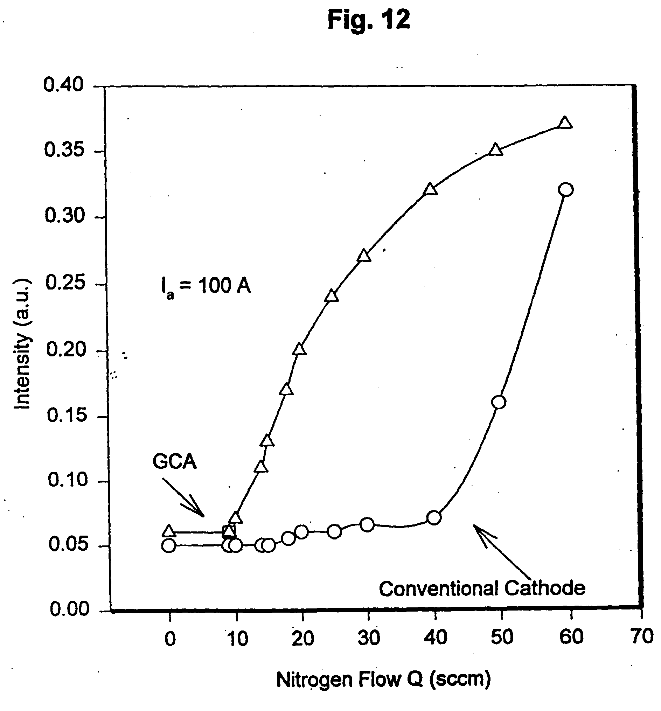

Spectral measurements of the arc discharge in the vicinity of the cathode surface (i.e., at 20 mm therefrom) were carried out at various nitrogen flow rates (0-60 sccm) for cathodes used in both the GCA process and in the conventional arc deposition process. These results are graphically illustrated in Figs. 11 and 12. Fig. 11 shows the relative intensity variations of a titanium spectral line (TiI, $\gamma = 5210$ Å) as a function of nitrogen flow rate at a cathode current of 100 amps. Fig. 12 shows the relative intensity variations of an $N_2^+$ spectral line ($N^2II$, $\gamma = 3914$ Å) as a function of nitrogen flow rate at a cathode current of 100 amps. As previously observed for the cathode surface erosion rate, the titanium spectral line intensity decreases around or at the same gas flow rate at which formation of the erosion-reduction layer takes place. This fact directly confirms that thermal cathode spots which generate too much metal neutral vapor, transform to fast moving explosive cathode spots. The explosive cathode spot generates much less neutral metal vapor and more ionized atoms. Reduction of neutral particles in the plasma flow is very beneficial for the deposition of dense coatings with no porosity. Accordingly, the GCA process of this invention demonstrates an obvious advantage compared to conventional processes. Referring to Fig. 12, it will be noted that the spectral intensity of the $N_2^+$ line increases sharply at the process gas flow rate corresponding to the TiN layer formation on the cathode surface. At low gas flow rates, the GCA process demonstrates an advantage in generating nitrogen molecular ions.

Example Coatings

The inventive process provides several unique capabilities for the direct synthesis of multicomponent gas and metal compound and ternary coatings since it makes it possible to realize a steady vacuum arc discharge with large amounts of cathode materials, with low concentration of macroparticles in the plasma jets. For example, there have been serious problems in the deposition of smooth coatings using aluminum cathodes because the arc discharge is not stable on the cathode surface, and the vacuum arc generates a large amount of droplets or macroparticles. However, using the GCA process of the present invention, there is no problem in obtaining a steady vacuum arc with the aluminum cathode and nitrogen gas flow through a hole in the cathode. The formation of the aluminum nitride film on the cathode surface changes the character of the cathode spots and their motion, drastically reducing macroparticle generation. Further introduction of the process gas through the cathode gas inlet channel makes the arc discharge very stable. Accordingly, the principles of this invention enable the direct synthesis of (TiAl)N using two cathodes of pure aluminum and pure titanium, instead of using very expensive composite TiAl cathodes made by using powder metallurgy technology.

The method of this invention also provides the possibility to improve mechanical properties of the coatings due to activation of the process gas. The microhardness of the coatings, being sensitive to the phase composition and structure of the materials, characterizes the generalized value of the plastic resistance due to both the nitrogen content in the condensate and the distinctive features of its structure. The GCA processes' high degree of activation of the process gas also offers the prospect of deposition of complex coatings without any bias. Experiments have demonstrated the possibility of deposition of TiN on plastic and glass substrates without DC or RF bias on the substrate, with good adhesion.

Three example coatings made according to the principles of this invention were deposited according to the following examples.

Example #1

A TiN coating having extremely high microhardness was deposited according to the GCA process. The deposition parameters and coating properties for this coating are illustrated in the first column of Table 2.

Example #2

It is well-known that the coatings deposited with the aluminum cathode in the conventional arc process appear to be very rough. The roughness occurs as a result of the aluminum cathode emitting large numbers of macroparticles. Using the GCA deposition process, aluminum nitride coatings were successfully deposited with a very high grade of smoothness. The deposition parameters and coating properties for the AlN coating are illustrated in the second column of Table 2.

Example #3

As mentioned above, the present invention provides the possibility of direct synthesis of (TiAl)N using two cathodes from pure aluminum and pure titanium instead of using very expensive TiAl cathodes made by powder metallurgy technology. An (TiAl)N coating was deposited according to the GCA process of this invention using two cathodes from pure titanium and pure aluminum. The deposition parameters and coating properties for this coating film are given in column three of Table 2. As is evident from the Table 2 results, the coating properties for the coatings made with the GCA process are superior as compared to conventional arc processes using composite TiAl cathodes.

## Table 2.  Deposition Parameters and Coating Properties.

| Parameter | Example 1 | Example 2 | Example 3 |
|---|---|---|---|
| Coating Composition | TiN | AlN | (Ti,Al)N |
| Substrate | HSS M2 | HSS M2 | HSS M2 |
| Cathode Composition | Ti | Al | (#1) = Ti;<br>(#2) = Al |
| Spatial Standoff, cm | 25 | 25 | 25 |
| Chamber Pressure, mTorr | 2 | 2 | 3.1 |
| $N_2$ Flow Rate, sccm | 120 | 120 | through the evaporator (#1) 100;<br>through the evaporator (#2) 100 |
| Arc Current, Adc | 100 | 100 | evaporator #1-100<br><br>evaporator #2-100 |
| Substrate Bias, V | -150 | -50 | -150 |
| Substrate Temperature, °C | 400 | 400 | 400 |
| Deposition Rate, $\mu$m/min | 0.3 (without rotation) | 0.05* (d.c. bias) | 0.15 (with rotation) |
| Roughness, RA, Å | 160-240 | 200-220 | 180-190 |
| Microhardness, $H_v$, $N/mm^2$ | 4000-4050 | n/a | 5500-5600 (nanolayer structure) |

\* For comparison of the deposition rate with the deposition rate of other conductive coatings it is necessary to use R.F. bias because of semiconductor properties of AlN.

From the foregoing description, it will be appreciated that coatings deposited according to the gas controlled arc deposition process of this invention include the following desirable characteristics as compared to conventional arc deposition processes:

(1) Very low surface roughness due to reduction of macroparticles in plasma flow. For titanium this amounts to greater than five times reduction. For other metals, an order of magnitude is possible.

(2) High density coatings due to minimization of the neutral component of the cathode material and the process gas.

(3) High microhardness of the coatings (such as nitrides of the transition metals), due to the following:

(a) high coating density due to the reduction or elimination of porosity caused by macroparticles;
(b) less metallic neutral species being incorporated into the film; and
(c) the ability to deposit films at low chamber gas pressure leading to a more energetic deposition process, thereby improving density; and

(4) Improved control of crystallographic properties of coatings such as:

(a) film texture or orientation of crystal structure; and
(b) grain or crystal size.

It will be appreciated that while the present invention has been described with reference to particular embodiments and configurations of cathode structures, manners of introducing the processing gas and cooling regimes therefor, various alternative embodiments, design options and variations thereof will be apparent to those skilled in the art. Further, while the invention has been described with respect to its application in depositing certain materials as exemplified by the preferred embodiment descriptions and examples, and with certain types of process gases, the invention is not to be limited to such examples or to such process gases. It will also be appreciated that the principles of this invention can readily be incorporated with or into arc deposition systems that use other plasma and coating enhancement techniques and methods, to further improve upon such existing systems. For example, magnetic fields may be used to further enhance the plasma generation in manners well-known int he art. Also, the invention could be used with nonline-of-sight deposition systems such as the curvilinear or steered arc type of systems. These and other possible applications for the invention will be readily appreciated by those skilled in the art. Accordingly, The invention is not to be limited by any of the particulars of the preferred embodiments used to describe the invention, but only by the scope of the appended claims.

## Claims

1. A method of enhancing plasma generated from a cathode evaporation surface of a sacrificial cathode by an electric arc in a vapor deposition chamber, comprising the step of selectively introducing a process gas into the deposition chamber at a predetermined flow rate to create a process gas activation zone for enhancing plasma activation adjacent to the cathode evaporation surface.

2. The method of Claim 1, further including the step of mounting the cathode for operation in either a cold regime or a hot regime mode; wherein said process gas comprises a reactive or non-reactive gas or combination of reactive and non-reactive gases or vapors; and wherein the step of introducing the process gas comprises introducing said process gas through the cathode evaporation surface of said cathode by forcing said process gas through one or more passageways formed through the cathode and its cathode evaporation surface.

3. The method of Claim 2, wherein at least a portion of said cathode which forms the cathode evaporation surface is formed at least in part of porous material defining capillary passageways therethrough, and wherein said process gas is forced through said capillary passageways.

4. The method of Claim 1, wherein the cathode is an electrically conductive material of the class including metal, carbon or materials which become conductive as a function of doping or temperature.

5. The method of Claim 1, wherein the width of the process gas activation zone is proportional to the mean free paths of the cathode material ions and electrons in the process gas.

6. The method of Claim 1, wherein the width of the process gas activation zone is defined by: $h \leq \max(l_i l_e)$.

7. The method of Claim 1, wherein the process gas zone is located beyond the Langmuir sheath that occurs on the cathode evaporation surface during plasma generation, where cathode voltage potential drop begins.

8. The method of Claim 1, including the step of activating the process gas within the process gas activation zone by transferring charge from highly charged ions of the cathode material.

9. The method of Claim 1, including the step of activating the process gas within the process gas activation zone by causing non-elastic collisions of plasma electrons with atoms and molecules of the plasma gas.

10. The method of Claim 1, including the step of reducing thermal cathode spot generation on the cathode evaporation surface by means of said process gas activation zone, thereby reducing macroparticle introduction to the plasma.

11. The method of Claim 1, including the step of forming emission-active phase compounds on the cathode surface by means of the process gas activation zone, thereby lowering the threshold of synthesis reaction on the cathode evaporation surface.

12. The method of Claim 1, wherein said predetermined gas flow rate is a function of the type of material forming said cathode and of the type of said process gas.

13. The method of Claim 1, wherein said predetermined gas flow rate is a function of the discharge current of the arc.

14. The method of Claim 1, wherein said predetermined gas flow rate is greater than or equal to

$$I\left(\frac{Q_{cr}}{I_s}\right)^{\gamma}.$$

15. The method of Claim 1, further comprising the step of applying the plasma created by said method to a substrate in the vapor deposition chamber.

16. A substrate coated by a plasma created by the method of Claim 15.

17. An electric arc vacuum deposition process comprising the steps of:

(a) operatively configuring an anode, a first sacrificial cathode source and a substrate within a vacuum deposition chamber;
(b) evacuating the chamber;
(c) introducing a first process gas into the chamber at a first predetermined flow rate to create a first process gas activation zone adjacent to a cathode evaporation surface of the first cathode source;
(d) striking and maintaining an electric arc between the cathode evaporation surface of said first cathode and said anode, thereby vaporizing portions of said first cathode evaporation surface which combines with said process gas to form a first plasma; and
(e) directing said first plasma into engagement with said substrate.

18. The process of Claim 17, wherein said step of directing said first plasma into engagement with said substrate comprises conditioning a surface of said substrate with said first plasma.

19. The process of Claim 17, wherein said step of directing said first plasma into engagement with said substrate comprises nitriding a surface of said substrate with said first plasma.

20. The process of Claim 17, wherein said step of directing said first plasma into engagement with said substrate comprises coating a surface of said substrate with said first plasma.

21. The process of Claim 17, wherein the step of introducing the first process gas comprises introducing said first process gas through the cathode evaporation surface of the first cathode by passing the first process gas through one or more fluid flow passageways formed in said first cathode.

22. The process of Claim 17, wherein the chamber is evacuated to a predetermined evacuation pressure level, and further including the step of maintaining the predetermined evacuation pressure level during the deposition process.

23. The process of Claim 17, further including the steps of:

(a) operatively configuring a second sacrificial cathode source relative to said anode and said substrate within the vacuum deposition chamber;

(b) striking and maintaining an electric arc between the cathode evaporation surface of said second cathode and said anode, thereby vaporizing portions of said second cathode to create a second plasma; and directing said second plasma into engagement with said substrate.

24. The process of claim 23, including the step of introducing a second process gas into said chamber to create a second process gas activation zone adjacent to the cathode evaporation surface of said second cathode.

25. The process of Claim 23, further including the step of coating a surface of said substrate with said first and said second plasmas.

26. A substrate coated by a plasma created by the method of Claim 20.

27. A substrate coated by a plasma created by the method of Claim 25.

28. A sacrificial cathode for use in electric arc vapor deposition , wherein an electric arc is struck between the cathode and an anode within a vapor deposition chamber, comprising:

(a) a solid volume of source material configured to define at least one cathode evaporation surface to be struck by an arc; and

(b) wherein said volume of source material defines a gas passageway formed through said source material and extending from an inlet end to an outlet end, wherein said outlet end opens through said cathode evaporation surface.

29. The cathode of Claim 28, wherein said source material is an electrically conductive material of the class including metal, carbon, or materials which become conductive as a function of doping or temperature.

30. The cathode of Claim 28, wherein said source material comprises an alloy.

31. The cathode of Claim 28, wherein said cathode evaporation surface is configured to define a shaped depression surrounding the outlet end of said gas passageway.

32. The cathode of Claim 28, wherein at least a Dart of said solid volume of said source material that forms said cathode evaporation surface is of porous construction and wherein said outlet end of said gas passageway is configured to direct gas passing therethrough through said porous material such that said gas passes through said cathode evaporation surface.

33. The cathode of Claim 32, wherein the porosity of said cathode material is in the range of from about 15 to 85 percent.

34. An electric arc vapor deposition system, comprising:

(a) a vacuum deposition chamber;
(b) an anode in or forming a part of said deposition chamber;
(c) a sacrificial cathode source of material in said deposition chamber, said cathode having a cathode evaporation surface;
(d) a substrate arranged and configured in said deposition chamber to receive plasma material from the evaporation surface of said cathode;
(e) means operatively connected with said deposition chamber for evacuating said chamber;
(f) a power source operatively connecting said anode and said cathode for initiating and maintaining an arc between said cathode evaporation surface and said anode, thereby creating a plasma of source material; and
(g) a process gas delivery system operatively connected with said deposition chamber and said cathode for selectively delivering a process gas to said deposition chamber so as to form a process gas activation zone immediately adjacent to said cathode evaporation surface.

35. The deposition system of Claim 34, wherein said process gas delivery system includes means for delivering the process gas through the cathode evaporation surface of the cathode.

36. The deposition system of Claim 35, wherein said process gas delivery system includes a gas passageway defined by and through said sacrificial cathode source.

37. The deposition system of Claim 35, wherein said process gas delivery system includes a porous material forming at least a portion of said cathode source that defines the cathode evaporation surface, wherein the process gas flows through the porous material to said cathode evaporation surface.

FIG.1

FIG.4

FIG.2

FIG.3

# FIG.5a

# FIG.5b

## FIG. 6a

100KX18ud5r    00013    1µm

## FIG. 6b

10 KX18ud5r    00002    1µm

## Fig. 7

# Fig. 8

# Fig. 9

## Fig. 10

GCA    $I_a = 100\ A$

X-axis: Nitrogen Flow Q (sccm)
Y-axis: Discharge Voltage Drop (V)

## Fig. 11

## Fig. 12

Fig. 13

Fig. 14

Fig. 15

Fig.16

Fig. 17

Fig. 18